# EUROPEAN PATENT APPLICATION

(11) **EP 1 726 631 A1**
(43) Date of publication of application: **29.11.2006**
(21) Application number: 05011152.5
(22) Date of filing: 23.05.2005
(51) Int. Cl.: C09K 11/79, C09K 11/80, C09K 11/84

(54) **White light emitting device**

(71) Applicant: SuperNova Optoelectronics Corporation, Pingjhen City Taoyuan County 324 (TW)
(72) Inventor: Lai, Mu-Jen, Chungli City Tao Yuan Hsien (TW)
(74) Representative: Kador & Partner

(57) **Abstract**

A white light emitting device is disclosed. The white light emitting device is composed by two light-emitting layers that emit light with wavelength λ1 and λ2 respectively. Then a first phosphor is used to absorb part of the two wavelength light and emit light having a wavelength of λ3. Or use a second phosphor to absorb part of the light with one of the two wavelength of the light-emitting layers and emit light with wavelength λ4. By mixing the light of the two light emitting layers with wavelength λ1 and λ2 with the light having a wavelength of λ3 individually, or further with the light with a wavelength of λ4, a white light is generated.

## Description

### BACKGROUND OF THE INVENTION

The present invention relates to a white light emitting device, especially to a light emitting device and manufacturing method thereof that uses light emitting device with two light emitting layers and at least one phosphor to produce a white light emitting device with high color rendering.

Light emitting diode (LED) is a fine solid-state light source made of semiconductor material. The energy gap of electrons and electron-holes are affected by different material so that when electrons cross the junction from the n- to the p-type material, the electron-hole recombination process produces some photons in the IR or visible light zone. That is light with different colors such as red, orange, yellow, green, blue or invisible light.

LED is divided into visible LED and invisible LED. The visible LED types including red, yellow and orange LED are applied to various products such as backlight source for keyboards of mobile phones as well as personal digital assistant (PDA), indicators for consumer electronics, industrial equipment, and car instrument panels, automobile stop lights, outdoor LED display and traffic signs. The invisible LED types such as IrDA (Infrared Data Association), VCSEL (Vertical Cavity Surface Emitting Lasers) and LD (laser diode) are applied in communication. There are two major categories. Short wavelength infrared is for wireless communication such as IrDA module, remote controllers, and sensors while long wavelength infrared is as light source for communications in short distance.

Now part of the white LED is applied in illumination such as vanity lights, or decorative lights for automobiles. The rest (over 95%) is for LCD backlight source. In consideration of illuminative efficiency and life cycle, now LED is primarily for small-size backlight source. The white LED is expected to be applied to backlight sources for screens as well as flashlight for digital cameras on mobile phones. In near future, applications of the white LED are focused on backlight sources for large-size LCD and replacement for global illumination light sources.

The white LED consisting of high-brightness blue LED and YAG:Ce phosphor is viewed as an energy-saving light source of new generation. Moreover, white LED can also be produced by a UV LED in combination with R,G,B phosphor.

A mixed LED disclosed by US patent No. 5,998,925 is formed by a gallium nitride (GaN) chip being packaged with Yttrium Aluminum Garnet (YAG). The gallium nitride chip emits blue light (λₚ=400~530nm , Wd=30nm) and then the Yttrium Aluminum Garnet phosphor in combination with Ce³⁺ is excited by the blue light and emits the yellow light with peak wavelength of 550nm. A substrate of blue light LED with a wavelength from 200 to 500nm is disposed on a bowl reflection cavity and is covered by resin mixed with YAG. Part of the blue light emitted from the LED chip is absorbed by YAG phosphor while other part of the blue light is mixed with the yellow light from the YAG phosphor so as to emit white light.

In order to increase the component of red light for achieving high color rendering, the amount of Yttrium in YAG need to be increased. The light conversion efficiency of the YAG phosphor that emits red light is reduced according to the increase of the amount of the Yttrium. Thus if users want to obtain white light with high color rendering by this prior art, the light emitting efficiency is relatively reduced. Moreover, the US patent No. 6084250 discloses an ultraviolet LED mixed with R.G.B phosphors that absorbs ultraviolet light for producing white light. However, the light conversion efficiency of the phosphor that absorbs ultraviolet light available now is not as good as that of the YAG phosphor. Thus there is a need to research and develop an ultraviolet LED with higher efficiency.

Furthermore, a mixed LED disclosed in Taiwanese patent publication No. 546852 consists of a first light emitting layer as well as a second light emitting layer with fixed wavelength of two major peaks, and a tunneling barrier layer is formed between the two light emitting layers. By adjusting the thickness of the tunneling barrier layer, the tunneling of carriers in the tunneling barrier layer is changed so that the distribution of carriers involved in photoelectric conversion in the two light emitting area varies. Thus the relatively light emitting strength of the two major peaks is also varied. Therefore, the range of the first wavelength of the light from the first light emitting layer overlaps with the range of the second wavelength of the light from the second light emitting layer and the single chip emits mixed light (or white light) with specific color. For changing colors of the mixed light, only the thickness of the tunneling barrier layer need to be modified. Thus the manufacturing process of the mixed LED is simplified. However, the tunneling barrier layer between the two light emitting layers causes the increasing of operating voltage of the device. Thus there is a shortage in electricity saving.

### SUMMARY OF THE INVENTION

It is therefore a primary object of the present invention is to provide a white light emitting device that consists of a light emitting diode chip having two light-emitting layers; a first phosphor to absorb part of light from the two light-emitting layers as well as emits light with wavelength longer than the wavelength of the two light-emitting layers; and a second phosphor that absorbs part of light from one of the light-emitting layers and emits light with wavelength longer than that of the two light-emitting layers as well as the first phosphor. This light with longer wavelength is mixed with the light of the two light-emitting layers so as to produce a white light emitting device with high color rendering.

It is another object of the present invention is to provide a white light emitting device that consists of a light emitting diode chip having two light-emitting layers and at least one phosphor that absorbs part of the light from the two light-emitting layers as well as emits light with wavelength longer than that of light of the two light-emitting layers. This emitted light with longer wavelength is mixed with the light of the two light-emitting layers so as to produce a white light emitting device.

In order to achieve above object, a white light emitting device in accordance with the present invention includes two light emitting layers that emits light with wavelength λ 1 and λ2 respectively, a first phosphor that absorbs part of light with double wavelength of light emitting layers and emits light having a wavelength of λ3, and a second phosphor that absorbs part of light with wavelength of one of the two light emitting layers and emits light with a wavelength of λ4. By mixing the light with wavelength λ1, λ2 from the two light emitting layers with the light having a wavelength of λ3 or further with light with a wavelength of λ4, white light is generated.

### BRIEF DESCRIPTION OF THE DRAWINGS

The structure and the technical means adopted by the present invention to achieve the above and other objects can be best understood by referring to the following detailed description of the preferred embodiments and the accompanying drawings, wherein
Fig. 1 is a schematic drawing of a light emitting diode of an embodiment in accordance with the present invention;
Fig. 2A is a schematic drawing of a light emitting diode with phosphor of an embodiment in accordance with the present invention;
Fig. 2B is a schematic drawing of light emitted form a light emitting diode with phosphor of an embodiment in accordance with the present invention;
Fig. 3A is a schematic drawing of a light emitting diode with phosphor of an embodiment in accordance with the present invention;
Fig. 3B is a schematic drawing of light emitted form a light emitting diode with phosphor of an embodiment in accordance with the present invention;
Fig. 4A is a spectrum of YAG phosphor excited by a conventional blue LED;
Fig. 4B is a spectrum of the first phosphor excited by a conventional blue LED;
Fig. 4C is a spectrum of the first phosphor excited by a conventional purple LED;
Fig. 4D is a spectrum showing the first phosphor and the second phosphor simultaneously excited by a conventional purple LED;
Fig. 4E is a spectrum showing the first phosphor and the second phosphor simultaneously excited by a LED with two light emitting layers in accordance with the present invention.

### DETAILED DESCRIPTION OF THE PREFFERED EMBODIMENT

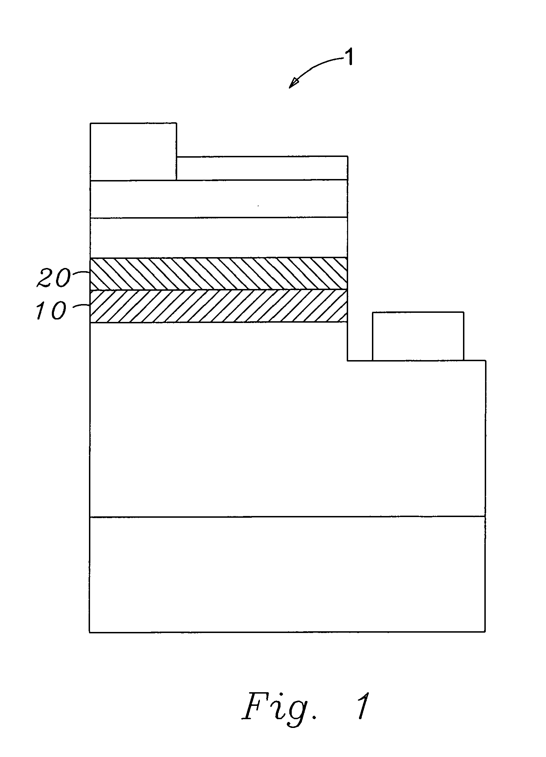

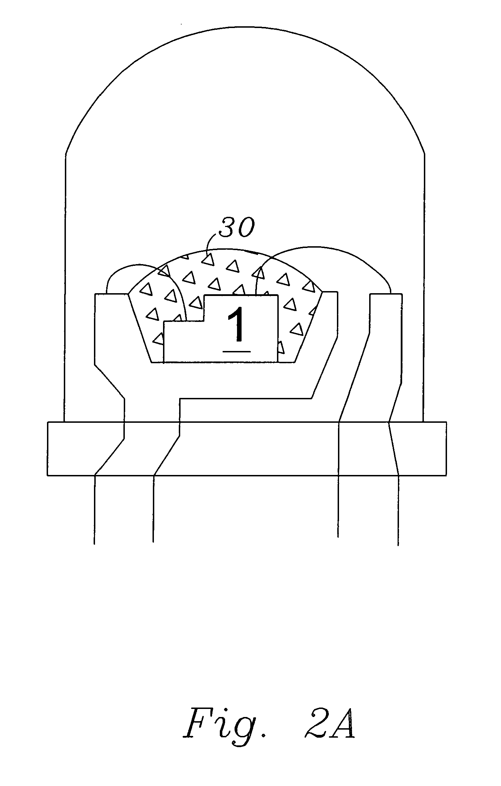

Refer to Fig.1, a light-emitting diode chip 1 is composed by a first light emitting layer 10 and a second light emitting layer 20, wherein the first light emitting layer 10 and the second light emitting layer 20 are formed by stacking of light-emitting gallium nitride-based III-V group compound semiconductor. The first light emitting layer 10 emits light with wavelength λ1-less than 430nm while the second light emitting layer 20 emits light with wavelength λ2 that ranges from no less than 430nm to 475nm.
Refer to Fig. 2A, the present invention further includes at least one first phosphor 30 that is made by one of the following substance:
(Y,Gd,Tb,Lu,Yb)(Al_{y}Ga_{1-y})₅O₁₂:Ce, SrGa₂S₄:Eu, ((Ba,Sr,Ca)(Mg,Zn))Si₂O₇:Eu, Ca₈Mg(SiO₄)₄Cl₂:Eu,Mn, (Ba,Sr,Ca)Al₂O₄:Eu, ((Ba,Sr,Ca)₁₋ₓEuₓ)(Mg,Zn)₁₋ₓMnₓ))Al₁₀O₁₇, ((Ba,Sr,Ca,Mg)₁₋ₓEuₓ)₂SiO₄, Ca₂MgSi₂O₇:Cl, SrSi₃O₈·2SrCl₂:Eu, Sr-Aluminate:Eu, Thiogallate:Eu, Chlorosilicate:Eu, Borate:Ce,Tb, BAM:Eu, Sr₄Al₁₄O₂₅:Eu, YBO₃:Ce,Tb, BaMgAl₁₀O₁₇:Eu,Mn, (Sr,Ca,Ba)(Al,Ga)₂S₄:Eu, Ca₂MgSi₂O₇:Cl,Eu,Mn, ZnS:Cu,Al, (Sr,Ca,Ba,Mg)₁₀(PO₄)₆Cl₂:Eu, Sr₅(PO₄)₃Cl:Eu, (Sr_{1-x-y-z}BaₓCa_{y}Eu_{z})₂SiO₄, and (Sr_{1-a-b}Ca_{b}Ba_{c})SiₓN_{y}O_{z}:EUₐ.

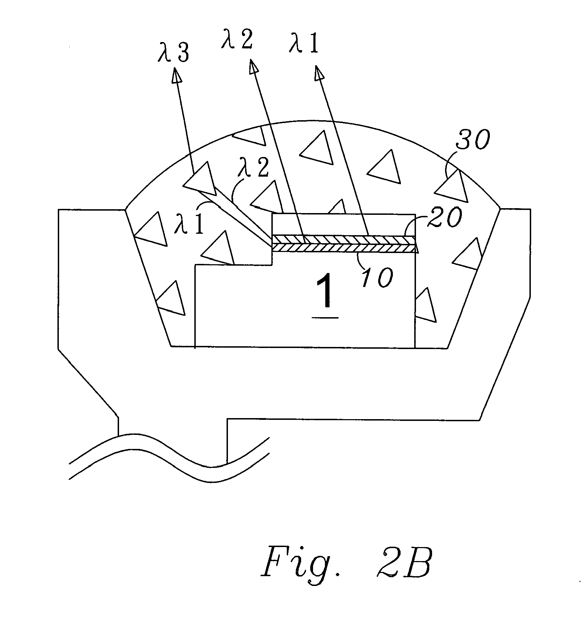

The first phosphor 30 absorbs part of the light with wavelength λ1 as well as the light with wavelength λ2 simultaneously from the two light emitting layers 10, 20 and emits light having a wavelength of λ3 that ranges from no less than 520nm to 600nm. The above light with different wavelength λ1, λ2 and λ3 are mixed so as to generate white light and the wavelength λ1 is less than λ2, λ2 is less than λ3, as shown in Fig.2B.

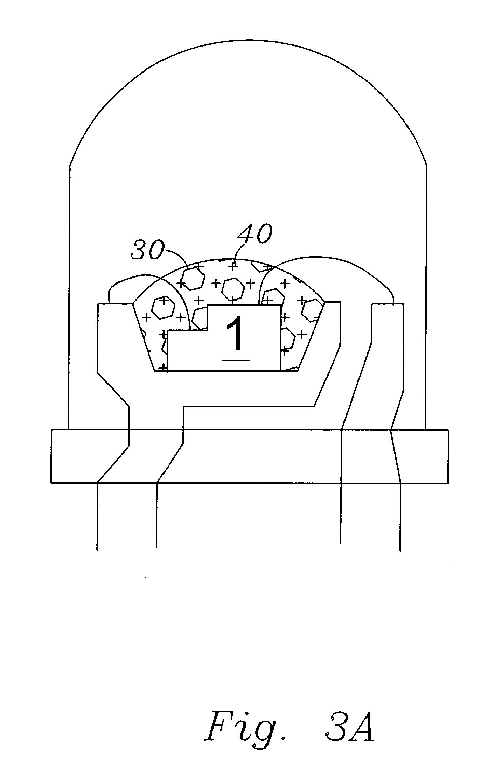

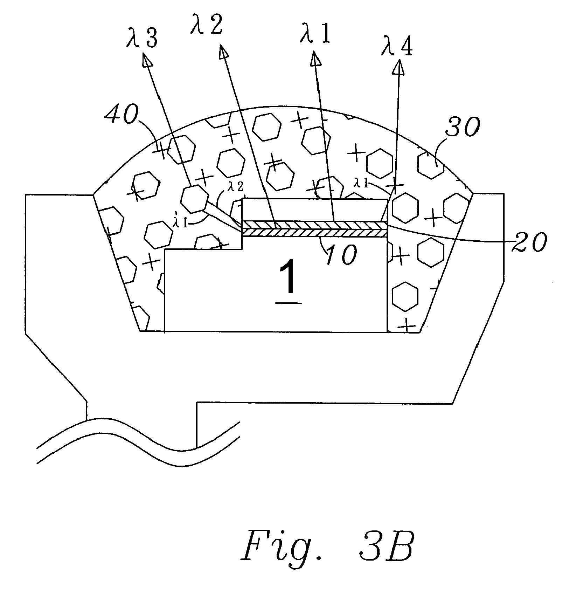

Moreover, refer to Fig. 3A & Fig. 3B, a light emitting diode of an embodiment in accordance with the present invention includes a first phosphor 30 that absorbs part of the light with wavelength λ1 as well as the light with wavelength λ2 from the two light emitting layers 10, 20 simultaneously and emits light having a wavelength of λ3 that ranges from no less than 520nm to 600nm and a second phosphor 40 that only absorbs part of light of the light emitting layer 10 and emits light with wavelength λ4 which ranges from no less than 600nm to 680nm. Then above light with various wavelength λ1 , λ2, λ3 and λ4 are all mixed to generate white light with high color rendering and wide wavelength spectrum. And the wavelength λ1 is less than λ2, λ2 is less than λ3, and λ3 is less than λ4(λ1<λ2<λ3<λ4).

The first phosphor 30 is made by one of the following substances:
(Y,Gd,Tb,Lu,Yb)(Al_{y}Ga_{1-y})₅O₁₂:Ce, SrGa₂S₄:Eu, ((Ba,Sr,Ca)(Mg,Zn))Si₂O₇:Eu, Ca₈Mg(SiO₄)₄Cl₂:Eu,Mn, (Ba,Sr,Ca)Al₂O₄:Eu, ((Ba,Sr,Ca)₁₋ₓEuₓ)(Mg,Zn)₁₋ₓMnₓ))Al₁₀O₁₇, ((Ba,Sr,Ca,Mg)₁₋ₓEUₓ)₂SiO₄, Ca₂MgSi₂O₇:Cl, SrSi₃O₈·2SrCl₂:Eu, Sr-Aluminate:Eu, Thiogallate:Eu, Chlorosilicate:Eu, Borate:Ce,Tb, BAM:Eu, Sr₄Al₁₄O₂₅:Eu, YBO₃:Ce,Tb, BaMgAl₁₀O₁₇:Eu,Mn, (Sr,Ca,Ba)(Al,Ga)₂S₄:Eu, Ca₂MgSi₂O₇:Cl,Eu,Mn, ZnS:Cu,Al, (Sr,Ca,Ba,Mg)₁₀(PO₄)₆Cl₂:Eu, Sr₅(PO₄)₃Cl:Eu, (Sr_{1-x-y-z}BaₓCa_{y}Eu_{z})₂SiO₄, or (Sr_{1-a-b}Ca_{b}Ba_{c})SiₓN_{y}O_{z}:EUₐ.

The second phosphor 40 is made by one of the following substances:
(Y,Gd,Tb,Lu,Yb)(Al_{y}Ga_{1-y})₅O₁₂:Ce, SrCa₂S₄:Eu, Y₂O₃:Eu,Gd,Bi, Y₂O₂S: Eu,Gd,Bi, SrAl₂O₄:Eu, Ca(EU₁₋ₓLaₓ)₄Si₃O₁₃, GdV04:Eu,Bi, Y(P,V)04:Eu,Pb, CaTi03:Pr,Bi, Sr₂P₂O₇:Eu,Mn, Sulfides:Eu(AES:Eu), CaSrS:Br, Mg₆As₂O₁₁:Mn, MgO·MgF₂·GeO₂:Mn, Ca₈Mg(SiO₄)₄Cl₂:Eu,Mn, CaAl₂O₄:Eu,Nd, Biₓ(Y,La,Gd)₁₋ₓ:Eu,Sm,Pr,Tb, Nitrido-silicates:Eu(AE₂Si₅N₈:Eu²⁺), GaSrS:Eu , ((Sc,Y,La,Gd)ₓ(Eu)₁₋ₓ)O₂S, Ca₅(PO₄)₃Cl:Eu,Mn, CaLa₂S₄:Ce , (Ba₁₋ₓ₋ₐCaₓ)Si₇N₁₀:Eu, (Ca₁₋ₐSiN₂:Euₐ), ((Gd,La,Y)ₘ(Ta,Zr,W,Mo,Zn)ₙ(Al,Mg,Sr)ₖ)Oₓ:Tm,Eu,Tb, Ce or SrY₂S₄:Eu.

Furthermore, in another embodiment of the present invention, the second phosphor 40 individually absorbs part of the light of the light emitting layer 20 and emits light with wavelength λ4 which ranges no less than 600nm to 680nm. The light with various wavelength λ1, λ2, λ3 and λ4 are all mixed to generate white light with high color rendering and wide wavelength spectrum. And the wavelength λ1 is less than λ2, λ2 is less than λ3, and λ3 is less than λ4(λ1<λ2<λ3<λ4). While the second phosphor 40 is made by one of the following substances:
(Y,Gd,Tb,Lu,Yb)(Al_{y}Ga_{1-y})₅O₁₂:Ce, SrxGa1-xS:Cl,Eu, Y₂O₂S: Eu,Gd,Bi, YVO₄:Eu,Gd,Bi, (Ca,Sr)S:Eu,Cl,Br, SrY₂S₄:Eu, SrGa₂S₄:Eu, CaLa₂S₄:Ce, Ca(Eu₁₋ₓLaₓ)₄Si₃O₁₃, CaTiO3:Pr³⁺,Bi³⁺, (Sr_{1-x-y-z}BaₓCa_{y}Eu_{z})₂SiO₄, Sulfides:Eu(AES:Eu²⁺), Mg₆As₂O₁₁:Mn, CaAl₂O₄:Eu,Nd, (Ca,Sr,Ba)S₂:Eu, Biₓ(Y,La,Gd)₁₋ₓ:Eu,Sm,Pr,Tb or Nitrido-silicates:Eu(AE₂Si₅N₈:Eu).

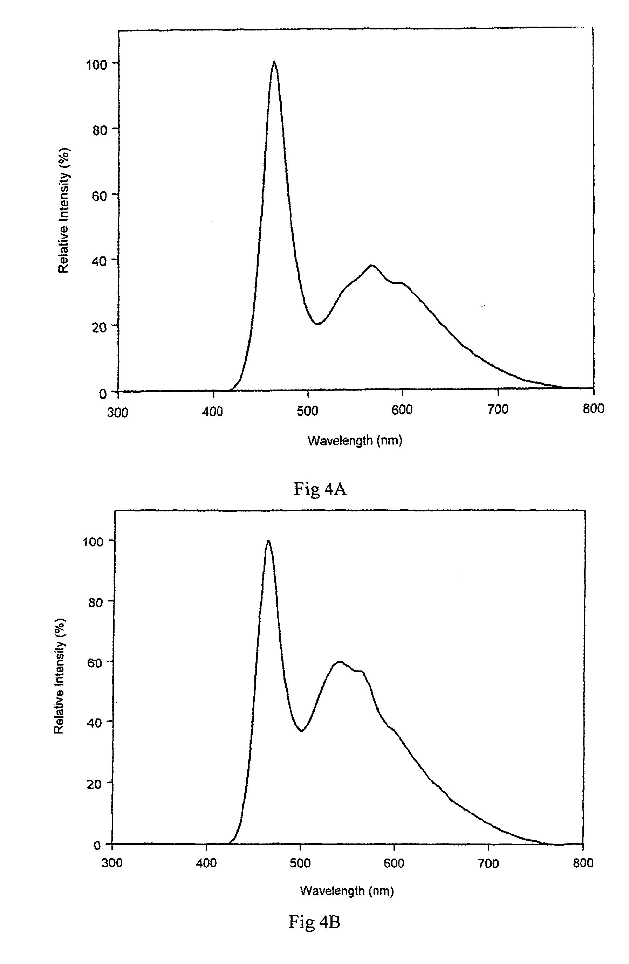

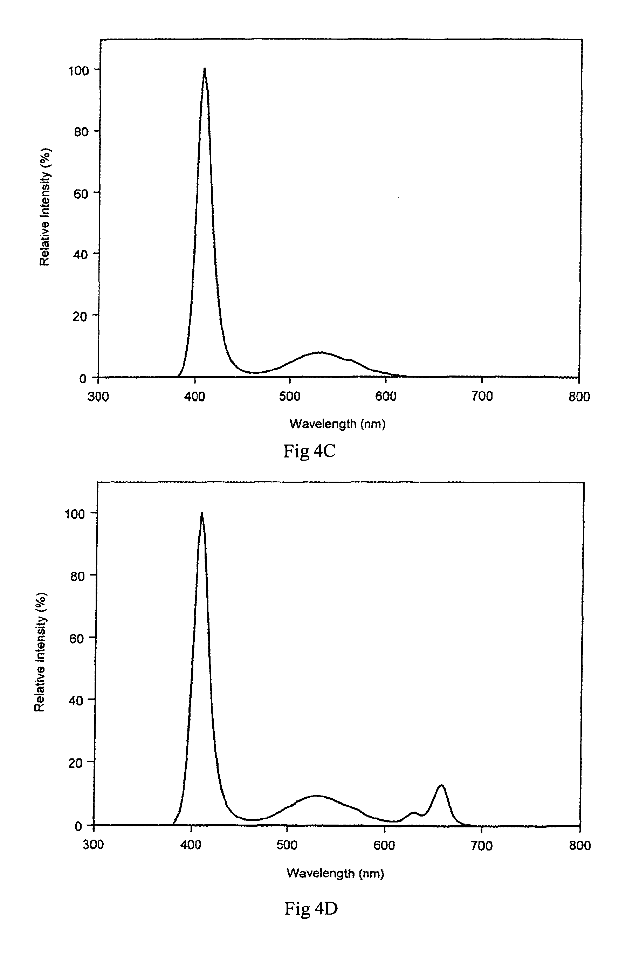

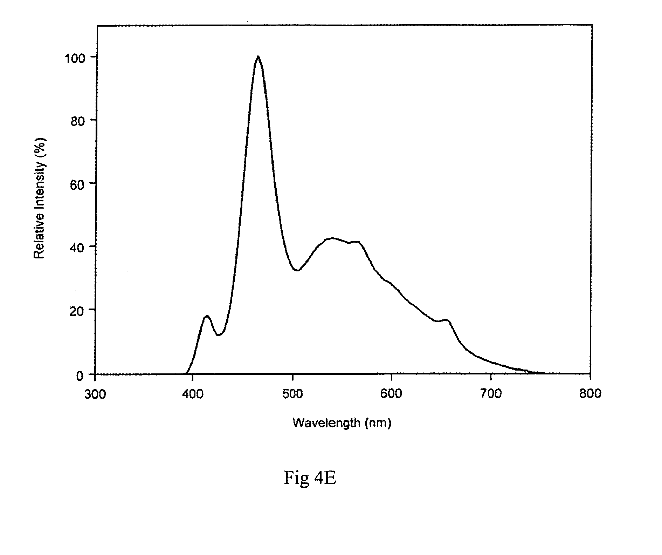

Refer to Fig. 4A, a conventional blue LED emits light with wavelength 460nm. After adding a YAG phosphor of a prior art, the light emitted is with wavelength 575nm and render index near 80. With reference of Fig. 4B, a conventional blue LED that emits light with wavelength 460nm is added with the fist phosphor in accordance with the present invention and then the light being emitted is with wavelength 535nm. Refer to Fig. 4C, a conventional violet LED that emits light with wavelength 405nm is added with the fist phosphor and then the light being emitted is with wavelength 535nm. When the violet LED having a wavelength of 405nm is added with the fist phosphor as well as the second phosphor simultaneously, the light being emitted from the second phosphor is with wavelength 660nm while the light from the first phosphor is with wavelength 535nm. Refer to Fig. 4D, the two light emitting layers in accordance with the present invention is added with the fist phosphor as well as the second phosphor simultaneously so as to increase the color rendering, as shown in Fig. 4E, the render index is increased to 90.

Additional advantages and modifications will readily occur to those skilled in the art. Therefore, the invention in its broader aspects is not limited to the specific details, and representative devices shown and described herein. Accordingly, various modifications may be made without departing from the spirit or scope of the general inventive concept as defined by the appended claims and their equivalents.

## Claims

1. A white light emitting device comprising:
a light emitting diode chip having two light-emitting layers that emit light with wavelength λ1 and λ2 respectively;
a first phosphor that absorbs part of the light with wavelength λ1 as well as the light with wavelength λ2 simultaneously and emits lights having a wavelength of λ3; and
a second phosphor that absorbs part of the light with wavelength λ1 and emits light with a wavelength of λ4;
wherein the light with wavelength λ1 is mixed with the light with wavelength λ2, the light having a wavelength of λ3, and the light with a wavelength of λ4 to generate white light.

2. The device as claimed in claim 1, wherein λ1 is less than λ2, λ2 is less than λ3, and λ3 is less than λ4.

3. The device as claimed in claim 2, wherein λ1, λ2, λ3, λ4 are within the ranges of λ1 <430nm, 430nm≦ λ2 <475nm, 520nm≦ λ3 <600nm, and 600nm≦ λ4 <680nm.

4. The device as claimed in claim 1, wherein the first phosphor is made by (Y,Gd,Tb,Lu,Yb)(Al_{y}Ga_{1-y})₅O₁₂:Ce, SrGa₂S₄:Eu,((Ba,Sr,Ca)(Mg,Zn))Si₂O₇:Eu, Ca₈Mg(SiO₄)₄Cl₂:Eu,Mn,(Ba,Sr,Ca)Al₂O₄:Eu,((Ba,Sr,Ca )₁₋ₓEuₓ)(Mg,Zn)₁₋ₓMnₓ))Al₁₀O₁₇,((Ba,Sr,Ca,Mg)₁₋ₓEuₓ)₂Si O₄,Ca₂MgSi₂O₇:Cl,SrSi₃O₈·2SrCl₂:Eu,Sr-Aluminate:Eu, Thiogallate:Eu,Chlorosilicate:Eu,Borate:Ce,Tb,BAM:Eu ,Sr₄Al₁₄O₂₅:Eu,YBO₃:Ce,Tb,BaMgAl₁₀O₁₇:Eu,Mn,(Sr,Ca ,Ba)(Al,Ga)₂S₄:Eu,Ca₂MgSi₂O₇:Cl,Eu,Mn,ZnS:Cu,Al,(Sr ,Ca,Ba,Mg)₁₀(PO₄)₆Cl₂:EU,Sr₅(PO₄)₃Cl:Eu,(Sr_{1-x-y-z}BaₓC a_{y}Eu_{z})₂SiO₄, or (Sr_{1-a-b}Ca_{b}Ba_{c})SiₓN_{y}O_{z}:Eu_{a.}

5. The device as claimed in claim 1, wherein the second phosphor is made by (Y,Gd,Tb,Lu,Yb)(Al_{y}Ga_{1-y})₅O₁₂:Ce, SrCa₂S₄:Eu, Y₂O₃:Eu,Gd,Bi, Y₂O₂S: Eu,Gd,Bi, SrAl₂O₄:Eu, Ca(Eu₁₋ₓLaₓ)₄Si₃O₁₃, GdV04:Eu,Bi, Y(P,V)O₄:Eu,Pb, CaTiO₃:Pr,Bi, Sr₂P₂O₇:Eu,Mn, Sulfides:Eu(AES:Eu), CaSrS:Br, Mg₆As₂O₁₁:Mn, MgO·MgF₂·GeO₂:Mn, Ca₈Mg(SiO₄)₄Cl₂:Eu,Mn, CaAl₂O₄:Eu,Nd, Biₓ(Y,La,Gd)₁₋ₓ:Eu,Sm,Pr,Tb, Nitrido-silicates:Eu(AE₂Si₅N₈:Eu²⁺), GaSrS:Eu , ((Sc,Y,La,Gd)ₓ(Eu)₁₋ₓ)O₂S, Ca₅(PO₄)₃Cl:Eu,Mn, CaLa₂S₄:Ce , (Ba₁₋ₓ₋ₐCaₓ)Si₇N₁₀:Eu, (Ca₁₋ₐSiN₂:Euₐ), ((Gd,La,Y)ₘ(Ta,Zr,W,Mo,Zn)ₙ(Al,Mg,Sr)ₖ)Oₓ:Tm,Eu,Tb, Ce or SrY₂S₄:Eu.

6. A white light emitting device comprising:
a light emitting diode chip having two light-emitting layers that emit light with wavelength λ1 and λ2 respectively;
a first phosphor that absorbs part of the light with wavelength λ1 as well as the light with wavelength λ2 simultaneously and emits lights having a wavelength of λ3; and
a second phosphor that absorbs part of the light with wavelength λ2 and emits light with a wavelength of λ4;
wherein the light with wavelength λ1 is mixed with the light with wavelength λ2, the light having a wavelength of λ3, and the light with a wavelength of λ4 to generate white light.

7. The device as claimed in claim 6, wherein λ1 is less than λ2, λ2 is less than λ3, and λ3 is less than λ4.

8. The device as claimed in claim 6, wherein λ1, λ2, λ3, λ4 are within the ranges of λ1<430nm, 430nm≦ λ2<475nm, 520nm≦ λ3<600nm, 600nm≦ λ4<680nm.

9. The device as claimed in claim 6, wherein the first phosphor is made by (Y,Gd,Tb,Lu,Yb)(Al_{y}Ga_{1-y})₅O₁₂:Ce, SrGa₂S₄:Eu, ((Ba,Sr,Ca)(Mg,Zn))Si₂O₇:Eu, Ca₈Mg(SiO₄)₄Cl₂:Eu,Mn, (Ba,Sr,Ca)Al₂O₄:Eu, ((Ba,Sr,Ca)₁₋ₓEuₓ)(Mg,Zn)₁₋ₓMnₓ))Al₁₀O₁₇, ((Ba,Sr,Ca,Mg)₁₋ₓEuₓ)₂SiO₄, Ca₂MgSi₂O₇:Cl, SrSi₃O₈·2SrCl₂:Eu, Sr-Aluminate:Eu, Thiogallate:Eu, Chlorosilicate:Eu, Borate:Ce,Tb, BAM:Eu, Sr₄Al₁₄O₂₅:Eu, YBO₃:Ce,Tb, BaMgAl₁₀O₁₇:Eu,Mn, (Sr,Ca,Ba)(Al,Ga)₂S₄:Eu, Ca₂MgSi₂O₇:Cl,Eu,Mn, ZnS:Cu,Al, (Sr,Ca,Ba,Mg)₁₀(PO₄)₆Cl₂:Eu, Sr₅(PO₄)₃Cl:Eu, (Sr_{1-x-y-z}BaₓCa_{y}Eu_{z})₂SiO₄, or (Sr_{1-a-b}Ca_{b}Ba_{c})SiₓN_{y}O_{z}:EUₐ.

10. The device as claimed in claim 6, wherein the second phosphor is made by (Y,Gd,Tb,Lu,Yb)(Al_{y}Ga_{1-y})₅O₁₂:Ce, SrxGa1-xS:Cl,Eu, Y₂O₂S: Eu,Gd,Bi, YVO₄:Eu,Gd,Bi, (Ca,Sr)S:Eu,Cl,Br, SrY₂S₄:Eu, SrGa₂S₄:Eu, CaLa₂S₄:Ce, Ca(Eu₁₋ₓLaₓ)₄Si₃O₁₃, CaTiO3:Pr³⁺,Bi³⁺, (Sr_{1-x-y-z}BaₓCa_{y}Eu_{z})₂SiO₄, Sulfides:Eu(AES:Eu²⁺), Mg₆As₂O₁₁:Mn, CaAl₂O₄:Eu,Nd, (Ca,Sr,Ba)S₂:Eu, Biₓ(Y,La,Gd)₁₋ₓ:Eu,Sm,Pr,Tb or Nitrido-silicates:Eu(AE₂Si₅N₈:Eu)

11. A white light emitting device comprising:
a light emitting diode chip having two light-emitting layers that emit light with wavelength λ1 and λ2 respectively; and
a phosphor that absorbs part of the light with wavelength λ1 and the light with wavelength λ2 simultaneously and emits lights having a wavelength of λ3;
wherein the light with wavelength λ1 is mixed with the light with wavelength λ2, and the light having a wavelength of λ3 to generate white light.

12. The device as claimed in claim 11, wherein λ1 is less than λ2 and λ2 is less than λ3.

13. The device as claimed in claim 11, wherein λ1, λ2, λ3 are within the ranges of λ1<430nm, 430nm≦λ2<475nm, 520nm≦ λ3<600nm.

14. The device as claimed in claim 11, wherein the phosphor is made by (Y,Gd,Tb,Lu,Yb)(Al_{y}Ga_{1-y})₅O₁₂:Ce, SrGa₂S₄:Eu, ((Ba,Sr,Ca)(Mg,Zn))Si₂O₇:Eu, Ca₈Mg(SiO₄)₄Cl₂:Eu,Mn, (Ba,Sr,Ca)Al₂O₄:Eu, ((Ba,Sr,Ca)₁₋ₓEuₓ)(Mg,Zn)₁₋ₓMnₓ))Al₁₀O₁₇, ((Ba,Sr,Ca,Mg)₁₋ₓEUₓ)₂SiO₄, Ca₂MgSi₂O₇:Cl, SrSi₃O₈·2SrCl₂:Eu, Sr-Aluminate:Eu, Thiogallate:Eu, Chlorosilicate:Eu, Borate:Ce,Tb, BAM:Eu, Sr₄Al₁₄O₂₅:Eu, YBO₃:Ce,Tb, BaMgAl₁₀O₁₇:Eu,Mn, (Sr,Ca,Ba)(Al,Ga)₂S₄:Eu, Ca₂MgSi₂O₇:Cl,Eu,Mn, ZnS:Cu,Al, (Sr,Ca,Ba,Mg)₁₀(PO₄)₆Cl₂:Eu, Sr₅(PO₄)₃Cl:Eu, (Sr_{1-x-y-z}BaₓCa_{y}Eu_{z})₂SiO₄ or (Sr_{1-a-b}Ca_{b}Ba_{c})SiₓN_{y}O_{z}:Eu_{a.}
